(19) Europäisches Patentamt
European Patent Office
Office européen des brevets

(11) **EP 4 614 176 A1**

(12) **EUROPEAN PATENT APPLICATION**

(43) Date of publication:
**10.09.2025 Bulletin 2025/37**

(21) Application number: **24161508.7**

(22) Date of filing: **05.03.2024**

(51) International Patent Classification (IPC):
**G01R 33/54** (2006.01)     **G01R 33/56** (2006.01)

(52) Cooperative Patent Classification (CPC):
**G01R 33/5607; G01R 33/543**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Koninklijke Philips N.V.**
**5656 AG Eindhoven (NL)**

(72) Inventors:
• **EGGERS, Holger**
  **Eindhoven (NL)**
• **KEUPP, Jochen**
  **Eindhoven (NL)**

(74) Representative: **Philips Intellectual Property & Standards**
**High Tech Campus 52**
**5656 AG Eindhoven (NL)**

(54) **MR IMAGING USING FAT SUPPRESSION BY SELECTIVE INVERSION**

(57) The invention relates to a system and associated method of magnetic resonance imaging. The method comprises: subjecting at least one portion of the object (10) to a preparation sequence (PRE) comprising a spectrally selective inversion radiofrequency, RF, pulse (21) having a flip angle ($\alpha$) to selectively invert nuclear magnetization associated with fat protons within the at least one portion of the object (10); after a delay time ($T_D$), subjecting the at least one portion of the object (10) to an imaging sequence (1M) comprising at least one excitation RF pulse (28) and switched magnetic field gradients (29) to generate magnetic resonance, MR, signals (27), wherein the delay time ($T_D$) and/or the flip angle ($\alpha$) are determined such that contributions from a first spectral species of fat protons affected by the inversion RF pulse (21) and a second spectral species of fat protons not affected by the inversion RF pulse (21) to the MR signals substantially cancel each other out; acquiring the MR signals (27) from the at least one portion of the object (10); and reconstructing an MR image from the acquired MR signals (27), wherein contributions from both the first and second spectral species of fat protons are suppressed in the MR image due to the selective inversion by the preparation sequence (PRE) in combination with the determined delay time ($T_D$) and/or flip angle ($\alpha$).

Fig. 2

**Description**

**FIELD OF THE INVENTION**

The invention relates to the field of magnetic resonance (MR) imaging. It concerns a method of MR imaging of an object placed in a main magnetic field $B_0$. The invention also relates to an MR system and to a computer program to be run on an MR system.

**BACKGROUND OF THE INVENTION**

Image-forming MR methods that utilize the interaction between magnetic fields and nuclear spins in order to form two-dimensional or three-dimensional images are widely used nowadays, notably in the field of medical diagnostics, because they are superior to other imaging methods in many aspects for imaging soft tissue due to not requiring ionizing radiation and usually being not invasive.

A key challenge in MR imaging is the differentiation of tissues, particularly in distinguishing pathological tissues from surrounding fat, which can obscure critical details. To address this, specialized MR imaging techniques have been developed for fat suppression, among which "Spectral Presaturation with Inversion Recovery" (SPIR) and "Spectral Attenuated Inversion Recovery" (SPAIR) are prominent. These techniques enhance tissue contrast by selectively suppressing contributions from fat protons to the generated and acquired MR signals.

SPIR is a technique that combines spectral pre-saturation with the inversion recovery method to suppress fat signals in MR images. It is performed by first applying a spectrally selective inversion radiofrequency (RF) pulse that is specifically tuned to the resonance frequency of fat protons. This RF pulse achieves a selective partial inversion of the nuclear magnetization associated with fat protons without significantly affecting the nuclear magnetization of water protons or other tissues. The spectrally selective inversion RF pulse has a flip angle determining the extent of magnetization inversion. Following this, a delay time passes allowing the nuclear magnetization of fat protons to recover towards its equilibrium state. By carefully determining the flip angle and the delay time such that the start of the then following imaging sequence coincides with the null point of fat nuclear magnetization, i.e. the moment when the longitudinal nuclear magnetization of fat protons is zero, the MR signal contributions from fat protons are minimized in the resulting MR image. Contributions from other tissues to the MR signal are not selectively inverted and are thus not suppressed in the MR image. Their respective longitudinal nuclear magnetization is in the equilibrium at the time point at which the imaging sequence starts. SPIR is particularly useful in areas where fat and other tissues are closely intermixed, such as in the breast, liver, and musculoskeletal system, providing images that are better suited for diagnostic purposes.

SPAIR is a refinement of the hereinbefore described SPIR technique. Similar to SPIR, SPAIR involves applying a spectrally selective RF inversion pulse. However, it is designed to fully invert the magnetization of fat, i.e. the flip angle of the RF inversion pulse is 180°. SPAIR employs an adiabatic inversion RF pulse, which fully inverts the magnetization of fat even when the $B_1$ field is spatially nonuniform, making the technique less susceptible to variations in $B_1$. SPAIR is highly valued in abdominal, pelvic, and orthopedic imaging, where consistent fat suppression across large fields of view is critical for accurate diagnosis.

By selectively targeting the suppression of the MR signal from fat protons while preserving or enhancing the MR signal from other tissues, SPIR and SPAIR greatly aid in the diagnosis and assessment of various medical conditions, from detecting tumors and lesions to evaluating musculoskeletal injuries.

Chemical shift-selective fat suppression methods like SPIR and SPAIR are effective at eliminating the main spectral components of the fat signal that originate from the bulk methylene protons, as well as from other (aliphatic) fat protons with chemical shifts that are at a sufficient spectral distance from the water proton resonance. However, there is also significant fat signal due to the olefinic protons (which constitute -5-10% of all fat protons). The chemical shift of the olefinic protons is close to that of water protons. Hence, the known SPIR and SPAIR techniques suppress the MR signal contributions from fat only partially. The remaining contribution of fat tissue in the reconstructed MR image can still obscure critical details and thus compromise the medical diagnosis.

**SUMMARY OF THE INVENTION**

From the foregoing it is readily appreciated that there is a need for an improved MR imaging technique. It is consequently an object of the invention to enable MR imaging with a more complete suppression of fat signals.

In accordance with the invention, a method of MR imaging of an object placed in a main magnetic field $B_0$ is disclosed.

The method of the invention comprises:

subjecting the object to a preparation sequence comprising a spectrally selective inversion RF pulse having a flip

angle ($\alpha$) to selectively invert nuclear magnetization associated with fat protons within the object;

after a delay time, subjecting the object to an imaging sequence comprising at least one excitation RF pulse and switched magnetic field gradients to generate MR signals, wherein the delay time and/or the flip angle are determined such that contributions from a first spectral species of fat protons affected by the inversion RF pulse and a second spectral species of fat protons not affected by the inversion RF pulse to the MR signals substantially cancel each other out;

acquiring the MR signals from the object; and

reconstructing or with other words generating an MR image from the acquired MR signals, wherein contributions from both the first and second spectral species of fat protons are suppressed in the MR image due to the selective inversion by the preparation sequence in combination with the determined delay time and/or flip angle.

The method of the invention employs a preparation sequence comprising a spectrally selective inversion RF pulse to invert nuclear magnetization associated with fat protons at least partially, depending on the flip angle. The inversion RF pulse is optionally followed by a spoiler magnetic field gradient pulse to de-phase any transverse magnetization.

In the conventional SPIR and SPAIR techniques, as described above, the delay time and/or the flip angle are chosen to null the longitudinal nuclear magnetization of the fat protons affected by the spectrally selective inversion RF pulse. The invention deviates from this conventional approach by instead determining the delay time and/or the flip angle in such a way that the contributions to the MR signals from a first spectral species of fat protons (mainly originating from methylene protons) inverted by the inversion RF pulse and a second spectral species of fat protons (mainly originating from olefinic protons) not affected by the inversion RF pulse substantially cancel each other out at the instant at which the delay time (the duration of the time interval between the inversion RF pulse and the start of the imaging sequence) has lapsed. The terminology substantially cancel each other out is understood in the light of the invention as the difference between the longitudinal nuclear magnetization of the first and second spectral species of fat protons being less than 5% of part of the nuclear magnetization associated with fat protons that has been inverted by the spectrally selective inversion RF pulse, preferably less than 2.5%, more preferably less than 1% and most preferably less than 0.5%.

It has to be noted that the formulation "affected by the inversion RF pulse" used herein means that the nuclear magnetization of the first spectral species of fat protons experiences a flip angle which corresponds largely to the nominal angle $\alpha$ of the inversion RF pulse, while the formulation "not affected by the inversion RF pulse" does not exclude any influence of the inversion RF pulse on the nuclear magnetization of the second spectral species of fat protons. Depending on the spectral characteristics of the inversion RF pulse, a certain residual effect on the nuclear magnetization of the protons whose resonance lies outside the design bandwidth of the inversion RF pulse cannot be completely avoided in practice. It can at least be assumed as a good approximation that the effective flip angle of the inversion RF pulse for the nuclear magnetization of the second spectral species of fat protons is close to zero.

The present invention thus achieves a full suppression of the signal contribution from fat by adopting the basic principle of the known SPIR and SPAIR techniques. However, the invention suggests integrating the multi-peak spectrum of fat protons into the determination of the flip angle and/or the delay time to balance the inverted and non-inverted signal components from fat protons in the following imaging sequence such that they cancel out due to their opposite phases. In principle, any conventional imaging sequence can be used to image the water protons (not affected by the preparation sequence).

In a possible embodiment, the preparation sequence uses an adiabatic inversion RF pulse. This corresponds to the SPAIR technique. The adiabatic inversion RF pulse is designed to fully invert the magnetization of fat, i.e. the first spectral species of fat protons that fall into the bandwidth of the spectrally selective inversion RF pulse. The flip angle of the RF inversion pulse is thus fixed at 180°. Only the delay time is available as a tuning parameter to achieve that the signal contributions from the first and second spectral species cancel each other out according to the approach of the invention.

The first spectral species may include at least one of: methyl protons resonating at -3.8 ppm relative to water protons, methylene protons resonating at -3.4 ppm relative to water protons, $\beta$- and $\alpha$-carboxyl protons resonating at -3.1 ppm and -2.5 ppm relative to water protons, respectively, $\alpha$-olefinic protons resonating at -2.7 ppm relative to water protons, diacyl protons resonating at -1.9 ppm relative to water protons.

The second spectral species may include at least one of: olefinic protons resonating at +0.6 ppm relative to water protons, glycerol protons resonating at +0.5 ppm and -0.5 ppm relative to water protons.

The flip angle $\alpha$ of the spectrally selective inversion RF pulse determines the extent of magnetization inversion, i.e. the amount of negative longitudinal magnetization associated with the first spectral species of fat protons after the inversion RF pulse. Nuclear magnetization of water protons as well as of other fat protons (second spectral species), mainly olefinic protons with a chemical shift close to that of water protons, are not affected by the inversion RF pulse.

To suppress fat signals as completely as possible, it may be useful, optionally, to consider the different effective flip angles associated with the individual spectral peaks of the first and second spectral species of fat protons in the determination of the delay time and/or the flip angle of the inversion RF pulse. The individual effective flip angles of the protons of the first and second spectral species are related to the nominal flip angle by the spectral profile of the spectrally selective inversion RF pulse.

In one of the embodiment, different longitudinal relaxation times of the first and second spectral species are taken into account in the determination of the delay time and/or the flip angle. The protons of the first and second spectral species undergo longitudinal relaxation during the delay time. In order to obtain the desired balancing of the two spectral species at the instant at which the imaging sequence starts, possible different longitudinal relaxation times of the protons of the two spectral species should be considered.

In some embodiments, the imaging sequence is a spin echo sequence. In this case, in particular in the case of long echo times, different transverse relaxation times of the protons of the two spectral species become relevant and may disturb the desired balance. This may result in an incomplete fat suppression. This can be compensated for by also taking the echo time of the spin echo sequence and the different transverse relaxation times of the protons of the first and second spectral species into account in the determination of the delay time and/or the flip angle.

In some another embodiments, the imaging sequence is a gradient echo sequence. In this case, an echo time of the gradient echo sequence and the phase relation between the protons of the first and second spectral species can be taken into account in the determination of the delay time and/or the flip angle in order to achieve an optimized fat suppression.

The method of the invention described thus far can be carried out by means of an MR system including at least one main magnet coil for generating a uniform, steady magnetic field $B_0$ within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system.

The method of the invention can be advantageously carried out in most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system. The processing of the acquired MR signals for the reconstruction of MR images may also be performed on a computer which is separate from the MR system used for acquisition of the MR signals.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the method and system, as defined in the claims, is provided in the following written description of various embodiments of the disclosure and illustrated in the accompanying drawings.

## BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Figure 1 shows a block diagram of an MR system for carrying out the method of the invention.
Figure 2 schematically illustrates the method of the invention as a sequence diagram.

## DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a method, may be implemented in a system, a computer implemented method and/or in a computer program product, in a corresponding manner.

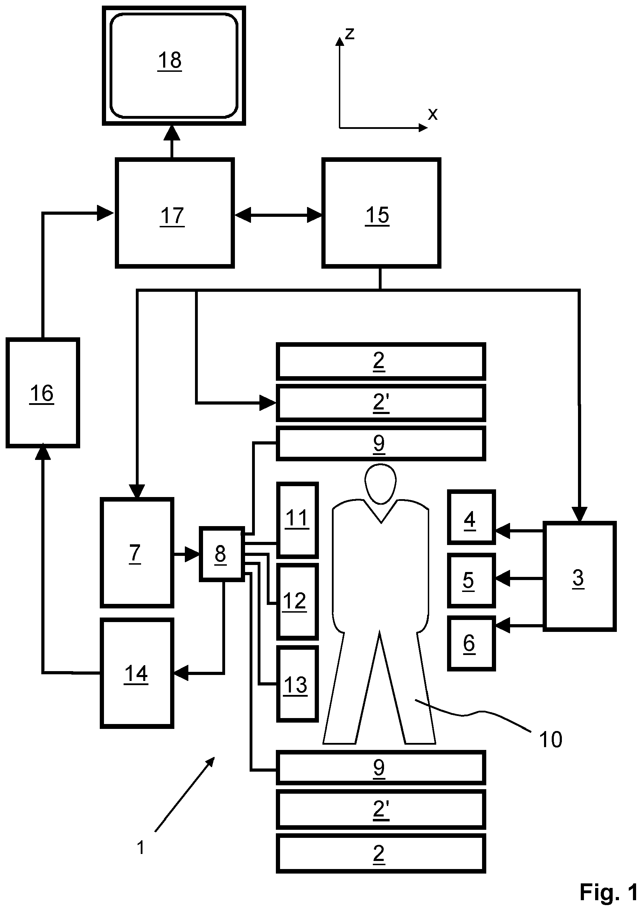

With reference to Figure 1, an MR system 1 is shown as a block diagram. The device comprises superconducting or resistive main magnet coils 2 such that a substantially uniform, temporally constant main magnetic field $B_0$ is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing $B_0$ deviations within the examination volume.

A magnetic resonance generation and manipulation system applies a series of RF pulses and switched magnetic field gradients to invert, excite, saturate, refocus, and spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. In particular, the RF pulses select a portion of a body 10 positioned in the examination volume. The MR signals are also picked up by the body RF coil 9.

For generation of MR images of limited regions of the body 10, a set of local array RF coils 11, 12, 13 are placed contiguous to the region selected for imaging. The array coils 11, 12, 13 can be used to receive MR signals induced by transmissions of the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15, in other words control unit, controls the shimming coils 2' as well as the gradient pulse amplifier 3 and the transmitter 7 to generate the imaging sequence of the invention. For the selected sequence, the receiver 14 receives signal data from a single or a plurality of k-space lines in rapid succession following each RF excitation pulse. A data acquisition system 16 performs analog-to-digital conversion of the received signals and converts each k-space line to a digital format suitable for further processing. In modern MR systems the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 or display screen, which provides a user-readable display of the resultant MR image.

The host computer 15 and the reconstruction processor 17 are configured, by corresponding programming, to perform the method of the invention described herein above and in the following.

A combination of any of the host computer 15, data acquisition system 16 and reconstruction processor 17 may be integrated in a single computational system.

The computational system may comprise a memory that may include volatile and nonvolatile memory storage means and components. The memory in some embodiments may be based on or may rely on cloud-based data stored in logical pools across disparate, commodity storage servers located on premises or in a data center managed by a third-party cloud provider. In some embodiments the image reconstruction may also be cloud-based reconstruction, wherein the digital raw image data is processed in the cloud and the reconstructed image is transmitted back to the system for outputting the result on the display screen 18. In such embodiments the digital raw data is transmitted to the cloud and the cloud-based image reconstruction function replaces or it may be additional to the reconstruction processor 17. Furthermore, the computational system may be a distributed computational system, consisting of multiple software components that are on multiple computers, running as a single computational system. The computers of the distributed computational system can be physically close together and connected by a local network, or they can be geographically distant and connected by a wide area network.

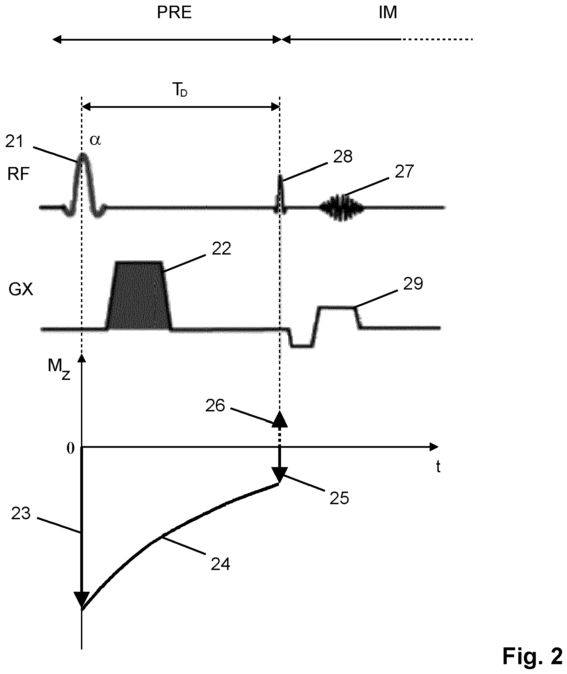

With continuing reference to Figure 1 and with further reference to Figure 2, an embodiment of the method of the invention is explained.

The diagram in Figure 2 illustrates the modified SPIR or SPAIR techniques according to the invention. The diagram shows the generation of radiofrequency (RF) pulses and the generation of switched magnetic field gradients (GX) as a function of time t. For the sake of simplicity, the diagram only shows the generation of magnetic field gradients in one spatial direction (x-direction). In the general case, magnetic field gradients are generated in all three spatial directions.

The method starts with subjecting the object 10 to a preparation sequence. The object 10 may be understood in the description as a subject or a portion of the body of a subject, wherein the subject may be a patient. The time interval during which the preparation sequence is applied is designated by PRE in Figure 2. The preparation sequence PRE comprises a spectrally selective inversion RF pulse having a flip angle $\alpha$ to selectively invert nuclear magnetization associated with fat protons within the object 10, which may be followed by a spoiler magnetic field gradient pulse 22 to de-phase any transverse nuclear magnetization.

The lower part of the diagram in Figure 2 illustrates the temporal evolution of the longitudinal nuclear magnetization $M_z$. The downwards pointing arrow 23 indicates the part of the nuclear magnetization $M_z$ associated with fat protons that has been inverted by the spectrally selective inversion RF pulse 21. These fat protons (first spectral species) are mainly methylene protons as well as other (aliphatic) fat protons. The flip angle $\alpha$ of the spectrally selective inversion RF pulse 21 determines the extent of magnetization inversion, i.e. the amount of negative longitudinal magnetization $M_z$ associated with the first spectral species of fat protons after the inversion RF pulse 21. Nuclear magnetization of water protons as well as of other fat protons (second spectral species), mainly olefinic protons with a chemical shift close to that of water protons, are not affected by the inversion RF pulse 21.

Following the inversion RF pulse, a delay time $T_D$ passes allowing the nuclear magnetization of the first spectral species of fat protons to recover towards its equilibrium state. This is indicated by the curve 24. The remaining negative longitudinal magnetization of the first spectral species at the instant at which the delay time $T_D$ has lapsed is indicated by arrow 25. The longitudinal nuclear magnetization of the second (not inverted) spectral species of fat protons at the same instant is indicated by dashed arrow 26 pointing in the positive direction. As can be seen in Figure 2, the longitudinal nuclear magnetization of the first (arrow 25) and second (dashed arrow 26) spectral species of fat protons cancel each other out after the delay time $T_D$ has lapsed. This is achieved by appropriate determination of the flip angle $\alpha$ and/or the delay time $T_D$. Thus, by carefully determining the flip angle $\alpha$ and/or the delay time $T_D$, the total longitudinal nuclear magnetization of fat (the superposition of the nuclear magnetization of the first and second spectral species of fat protons) is nulled at the instant at which the imaging sequence IM starts. Because of the cancelling out achieved in this way, the contributions of the first and second spectral species to the MR signals acquired during the imaging sequence IM have equal amplitude and opposed phases such that an effectively complete suppression of fat signal from both spectral species is obtained in an MR image reconstructed from the acquired MR signals 27. As in SPIR, contributions from water protons to the MR signal are not selectively inverted and are thus not suppressed in the MR image. Their respective longitudinal nuclear magnetization is in the equilibrium at the time point at which the imaging sequence IM starts.

In correspondence with the SPAIR technique, an adiabatic inversion RF pulse 21 may optionally be used, which fully inverts the magnetization of the first spectral species of fat protons even when the radiofrequency field $B_1$ is spatially non-uniform, making the technique less susceptible to variations in $B_1$. In this case, the flip angle $\alpha$ is 180°. The delay time $T_D$ is the only available parameter to be tuned in order to achieve the balancing of the nuclear magnetization of the two spectral species of fat protons according to the invention.

The imaging sequence IM may be any imaging sequence in principle. For the sake of simplicity, the diagram of Figure 2 shows only a first excitation RF pulse 28 and a readout magnetic field gradient pulse 29 of the imaging sequence IM. However, as is obvious to a skilled person, the imaging sequence may or will include a number of RF pulses 28 and switched magnetic field gradients 29 (in different spatial directions) to generate a number of frequency- and phase-encoded MR signals 27 and to sample a pre-determined region of k-space as required for the respective imaging task.

The determination of the flip angle $\alpha$ and the delay time $T_D$ in accordance with the invention is described more detailed in the following:
The effect of the conventional SPIR technique on the longitudinal magnetization $M_z$ of fat protons is described by:

$$M_z(t) = (M_z(0^-)\cos(\alpha) - 1)e^{-t/T_1} + 1 \qquad \text{(Eq. 1)}$$

where $M_z(0^-)$ denotes the fraction of the longitudinal magnetization before application of the SPIR inversion RF pulse at $t = 0$, and $T_1$ denotes the longitudinal relaxation time constant of the fat protons. This equation assumes a single-peak spectrum of fat and an infinitely short (partial) inversion RF pulse. In conventional SPIR, the angle $\alpha$ of the inversion RF pulse is chosen such that $M_z(t)$ crosses zero at $t = T_D$, when the excitation RF pulse for the subsequent imaging sequence is applied. Thus, it is given by

$$\alpha = \text{acos}((1 - e^{+T_D/T_1})/M_z(0^-)) \qquad \text{(Eq. 2)}$$

As explained above, SPAIR relies on a full inversion RF pulse with an invariable $\alpha = 180°$ and rather chooses the delay time such that $M_z(t)$ crosses zero at $t = T_D$. Thus, the delay is given by

$$T_D = T_1 \ln(1 + M_z(0^-)) \qquad \text{(Eq. 3)}$$

The design of both SPIR and SPAIR does not consider the multi-peak spectrum of fat protons, which causes the MR signal from fat to be suppressed only partially. The invention aims at fully suppressing the MR signal from fat with SPIR and SPAIR and suggests integrating a multi-peak spectrum of fat into the calculation of the flip angle $\alpha$ and/or the delay time $T_D$ and to balance the amplitudes of the MR signal components from fat protons (affected and not affected by the inversion RF pulse respectively) such that they cancel out due to their opposite phases.

Taking the multi-peak spectrum of fat protons into account, Eq. (1) is extended to

$$M_z(t) = \sum_n w_n \left( \left( M_{z,n}(0^-) \cos(\alpha_n) - 1 \right) e^{-t/T_{1,n}} + 1 \right) \qquad \text{(Eq. 4)}$$

where $n$ indexes the individual peaks and $w_n$ denotes the corresponding fraction of the longitudinal magnetization.

For the sake of simplicity, the differences in $T_1$ are ignored from here on, leading to

$$M_z(t) = \sum_n w_n \left( \left( M_{z,n}(0^-) \cos(\alpha_n) - 1 \right) e^{-t/T_1} + 1 \right) \qquad \text{(Eq. 5)}$$

The differences in $\alpha$ are, however, substantial, due to the spectral selectivity of the partial and full inversion RF pulses respectively. In a practical approximation, $\alpha$ is actually 0 for the peaks of fat protons that are close to the peak of water protons (second spectral species). For the other peaks of fat protons, which are termed first spectral species and include the dominant peak stemming from the methylene protons at -3.4 ppm relative to water protons, $\alpha$ is mostly the nominal $\alpha$. However, $\alpha$ may take on intermediate values for the peak of fat protons originating from the diacyl protons at -2.0 ppm relative to water protons, which may vary considerably with the spectral profile of the inversion RF pulse and the local main field inhomogeneity $\Delta B_0$. Again for the sake of simplicity, this is neglected in the following, given that the area of this peak is typically very small.

Assuming that the flip angle $\alpha$ is either 0 or the nominal $\alpha$, corresponding to fractions of the longitudinal magnetization of $w_0$ and $w_a$ respectively, Eq. (5) reduces to

$$M_z(t) = w_0 \left( \left( M_{z,0}(0^-) - 1 \right) e^{-t/T_1} + 1 \right) + w_\alpha \left( \left( M_{z,\alpha}(0^-) \cos(\alpha) - 1 \right) e^{-t/T_1} + 1 \right) \qquad \text{(Eq. 6)}$$

Requiring $M_z(t)$ to cross zero at $t = T_D$ leads to

$$\alpha = \mathrm{acos}\left( \left( \left( 1 - e^{+\frac{T_D}{T_1}} - \frac{w_0}{w_\alpha} \left( M_{z,0}(0^-) - 1 + e^{+\frac{T_D}{T_1}} \right) \right) \right) / M_{z,\alpha}(0^-) \right) \qquad \text{(Eq. 7)}$$

which replaces Eq. (2).

Solving for $T_D$ instead, given an invariable $\alpha = 180°$ (for SPAIR), results in

$$T_D = T_1 \ln \left( \left( w_0 + w_\alpha + w_0 M_{z,0}(0^-) - w_\alpha M_{z,\alpha}(0^-) \right) / (w_0 + w_\alpha) \right) \qquad \text{(Eq. 8)}$$

and with $w_0 + w_a = 1$ in

$$T_D = T_1 \ln \left( 1 + w_0 M_{z,0}(0^-) - w_\alpha M_{z,\alpha}(0^-) \right) \qquad \text{(Eq. 9)}$$

In both cases, the MR signal components from the first and second spectral species of fat protons cancel out due to their opposite phase ($\cos(\alpha) < 0$) and matched amplitude $(t = T_D)$.

While $M_{z,0}(0^-)$ depends on the RF pulses of the subsequent imaging sequence only, $M_{z,\alpha}(0^-)$ is also affected by the inversion RF pulse of the preparation sequence.

The difference between Eq. (2) and Eq. (9) is illustrated with an example:

A phantom containing sunflower oil with $w_0 = 0.14$, i.e. the second spectral species of fat protons account for 14% of the longitudinal magnetization, was imaged with SPIR, using $T_D = 10.6$ ms and single-shot turbo spin echo (TSE) imaging with low-high profile order. Setting $T_1 = 292$ ms, $\alpha = 92°$ and $\alpha = 102°$ was chosen according to Eq. (2) and Eq. (9), respectively. The signal intensity of the sunflower oil with SPIR with $\alpha = 92°$ equals 14% of that without SPIR. This matches the expectation from theoretical considerations based on the composition of the sunflower oil. The signal intensity with SPIR with 102° reduces to 2%, which comes close to an ideal suppression, in particular in view of the noise bias in magnitude images, which leads to positive average signal intensity even when the signal is actually zero.

In this example, the echo time (TE) is deliberately chosen to be short. If longer echo times are selected, differences in the

transverse relaxation time ($T_2$) of the individual peaks of fat protons become relevant. In particular, the $T_2$ of the first spectral species of fat protons is typically longer than the $T_2$ of the second spectral species of fat protons. This can be considered by weighting the two summands in Eq. (6) appropriately, which leads to

$$\alpha = \mathrm{acos}\left(\left(\left(1 - e^{+\frac{T_D}{T_1}} - \frac{w_0}{w_\alpha}e^{+\frac{TE}{T_{2,\alpha}}-\frac{TE}{T_{2,0}}}\left(M_{z,0}(0^-) - 1 + e^{+\frac{T_D}{T_1}}\right)\right)/M_{z,\alpha}(0^-)\right)\right) \qquad \text{(Eq. 10)}$$

The optimal $\alpha$ for SPIR is then lower. A similar $T_2$ correction can be included for $T_D$ in SPAIR. Similarly, other effects, such as J-coupling, can be considered.

Unlike in TSE imaging, the individual peaks of fat protons are not necessarily in phase anymore in turbo field echo (TFE) imaging. In general, this renders a general annihilation of the MR signal components from the first and second spectral species of fat protons impossible. However, it still allows a reduction of the residual fat signal. For instance, using a TE at which the phases of the MR signal components of the first and second spectral species are opposed, an $\alpha$ lower than 90° would actually be preferable. The MR signal components of the first and second spectral species will then still be aligned after SPIR, but precess with different frequencies after the excitation RF pulse of the imaging sequence, which will eventually result in the desired opposed phases at TE.

Although various embodiments of the claimed subject matter have been described above with a certain degree of particularity, or with reference to one or more individual embodiments, those skilled in the art could make numerous alterations to the disclosed embodiments without departing from the spirit or scope of the claimed subject matter.

Still other embodiments are contemplated. It is intended that all matter contained in the above description and shown in the accompanying drawings shall be interpreted as illustrative only of particular embodiments and not limiting. Changes in detail or structure may be made without departing from the basic elements of the subject matter as defined in the following claims.

**Claims**

1.    A method of imaging an object (10), comprising:

   subjecting at least one portion of the object (10) to a preparation sequence (PRE) comprising a spectrally selective inversion radiofrequency, RF, pulse (21) having a flip angle ($\alpha$) to selectively invert nuclear magnetization associated with fat protons within the at least one portion of the object (10);
   after a delay time ($T_D$), subjecting the at least one portion of the object (10) to an imaging sequence (IM) comprising at least one excitation RF pulse (28) and switched magnetic field gradients (29) to generate magnetic resonance, MR, signals (27), wherein the delay time ($T_D$) and/or the flip angle ($\alpha$) are determined such that contributions from a first spectral species of fat protons affected by the inversion RF pulse (21) and a second spectral species of fat protons not affected by the inversion RF pulse (21) to the MR signals substantially cancel each other out;
   acquiring the MR signals (27) from the at least one portion of the object (10); and
   reconstructing an MR image from the acquired MR signals (27), wherein contributions from both the first and second spectral species of fat protons are suppressed in the MR image due to the selective inversion by the preparation sequence (PRE) in combination with the determined delay time ($T_D$) and/or flip angle ($\alpha$).

2.    The method of claim 1, wherein the preparation sequence (PRE) comprises an adiabatic inversion RF pulse (21).

3.    The method of claim 1 or 2, wherein the second spectral species includes at least one of: olefinic protons resonating at +0.6 ppm relative to water protons, glycerol protons resonating at +0.5 ppm and -0.5 ppm relative to water protons.

4.    The method of any one of claims 1 to 3, wherein the first spectral species includes at least one of: methyl protons resonating at -3.8 ppm relative to water protons, methylene protons resonating at -3.4 ppm relative to water protons, $\beta$- and $\alpha$-carboxyl protons resonating at -3.1 ppm and -2.5 ppm relative to water protons, respectively, $\alpha$-olefinic protons resonating at -2.7 ppm relative to water protons, diacyl protons resonating at -1.9 ppm relative to water protons.

5.    The method of any one of claims 1 to 4, wherein different effective flip angles of the first and second spectral species of fat protons are taken into account in the determination of the delay time ($T_D$) and/or the flip angle ($\alpha$).

6. The method of claim 5, wherein the individual effective flip angles of the protons of the first and second spectral species of fat protons are related to the flip angle ($\alpha$) by the spectral profile of the spectrally selective inversion RF pulse (21).

7. The method of any one of claims 1 to 6, wherein different longitudinal relaxation times of the protons of the first and second spectral species are taken into account in the determination of the delay time ($T_D$) and/or the flip angle ($\alpha$).

8. The method of any one of claims 1 to 7, wherein the imaging sequence is a spin echo sequence.

9. The method of claim 8, wherein an echo time of the spin echo sequence and different transverse relaxation times of the protons of the first and second spectral species are taken into account in the determination of the delay time ($T_D$) and/or the flip angle ($\alpha$).

10. The method of any one of claims 1 to 7, wherein the imaging sequence is a gradient echo sequence.

11. The method of claim 10, wherein an echo time of the gradient echo sequence and the phase relation between the protons of the first and second spectral species are taken into account in the determination of the delay time ($T_D$) and/or the flip angle ($\alpha$).

12. A magnetic resonance system (1) comprising:

   a computational system configured to perform a method according to any of the claims 1 to 11; and
   a display screen (18) configured to display the reconstructed MR image.

13. The system of claim 12, further comprising at least one main magnet coil (2) for generating a static magnetic field within an examination volume, a plurality of gradient coils (4, 5, 6) for generating switched magnetic field gradients in different spatial directions within the examination volume, at least one radiofrequency, RF, coil (9) for generating RF pulses within the examination volume and/or for receiving magnetic resonance, MR, signals from at least one portion of the object (10) positioned in the examination volume.

14. The system of claim 12 or 13, wherein the computational system comprises:

   a control unit (15) for controlling the temporal succession of RF pulses and switched magnetic field gradients; and
   a reconstruction unit (17) for generating MR images from the received MR signals.

15. A computer program comprising machine executable instructions, wherein execution of the machine executable instructions causes a computational system to perform a method according to any of the claims 1 to 11.

**Fig. 1**

PRE

IM

$T_D$

21
α
RF

28

27

22

GX

29

$M_Z$

26

0

t

25

23

24

Fig. 2

# EP 4 614 176 A1

## EUROPEAN SEARCH REPORT

**Application Number**

EP 24 16 1508

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2011/267060 A1 (ABE TAKAYUKI [JP] ET AL) 3 November 2011 (2011-11-03)<br>* paragraphs [0038] - [0046], [0051] - [0059], [0072] - paragraph [0076]; figures 2, 4 * | 1,3-15<br><br>2 | INV.<br>G01R33/54<br>G01R33/56 |
| L | KURODA K ET AL: "OPTIMIZATION OF CHEMICAL SHIFT SELECTIVE SUPPRESSION OF FAT", MAGNETIC RESONANCE IN MEDICINE, WILEY-LISS, US, vol. 40, no. 4, 1 January 1998 (1998-01-01), pages 505-510, XP000889957, ISSN: 0740-3194<br>* the whole document * | 5-11 | |
| A | WINFIELD J M ET AL: "Phantom for assessment of fat suppression in large field-of-view diffusion-weighted magnetic resonance imaging", PHYSICS IN MEDICINE AND BIOLOGY, INSTITUTE OF PHYSICS PUBLISHING, BRISTOL GB, vol. 59, no. 9, 8 April 2014 (2014-04-08), pages 2235-2248, XP020261939, ISSN: 0031-9155, DOI: 10.1088/0031-9155/59/9/2235 [retrieved on 2014-04-08]<br>* page 2236 - page 2240; figures 1, 2, 3 *<br>* page 2246 * | 1-15 | **TECHNICAL FIELDS SEARCHED (IPC)**<br><br>G01R |

The present search report has been drawn up for all claims

| Place of search | Date of completion of the search | Examiner |
|---|---|---|
| Munich | 25 July 2024 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 1508

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2024

| Patent document cited in search report | Publication date | Patent family member(s) | | Publication date |
|---|---|---|---|---|
| US 2011267060 A1 | 03-11-2011 | EP | 2070475 A1 | 17-06-2009 |
| | | JP | 5118052 B2 | 16-01-2013 |
| | | JP | 5647655 B2 | 07-01-2015 |
| | | JP | 5898295 B2 | 06-04-2016 |
| | | JP | 2012236103 A | 06-12-2012 |
| | | JP | 2015024336 A | 05-02-2015 |
| | | JP WO2008044501 A1 | | 12-02-2010 |
| | | US | 2010013478 A1 | 21-01-2010 |
| | | US | 2011267060 A1 | 03-11-2011 |
| | | WO | 2008044501 A1 | 17-04-2008 |

For more details about this annex : see Official Journal of the European Patent Office, No. 12/82